# EUROPÄISCHE PATENTSCHRIFT

(11) **EP 2 596 078 B1**
(45) Veröffentlichungstag und Bekanntmachung des Hinweises auf die Patenterteilung: **03.12.2014**
(21) Anmeldenummer: 11730567.2
(22) Anmeldetag: 24.06.2011
(51) Int. Cl.: C09K 11/08, C09K 11/77, H05B 33/14

(54) **ALUMINAT-LEUCHTSTOFFE**
ALUMINATE LUMINESCENT SUBSTANCES
SUBSTANCES LUMINESCENTES À BASE D'ALUMINATE

(30) Priorität: 21.07.2010 DE 102010031755
(43) Veröffentlichungstag der Anmeldung: 29.05.2013
(73) Patentinhaber: Merck Patent GmbH, 64293 Darmstadt (DE)
(72) Erfinder: VOSGROENE, Tim, 64372 Ober-Ramstadt (DE); WINKLER, Holger, 64291 Darmstadt (DE); PETRY, Ralf, 64347 Griesheim (DE)
(86) Internationale Anmeldenummer: PCT/EP2011/003132
(87) Internationale Veröffentlichungsnummer: WO 2012/010244

(56) Entgegenhaltungen:
- WO-A1-2009/041297
- DE-A1-102007 022 566
- US-A1- 2004 062 699
- US-A1- 2009 196 030

## Beschreibung

Die Erfindung betrifft Aluminat-Verbindungen, Verfahren zur Herstellung dieser Verbindungen und deren Verwendung als Konversionsleuchtstoffe bzw. in Leuchtmitteln.

LEDs gewinnen zunehmend an Bedeutung - sowohl als Beleuchtungsmittel als auch bei der Verwendung als Hintergrundbeleuchtung in Flüssigkristall-Displays (FK-Displays). Diese neuartigen Lichtquellen weisen gegenüber den herkömmlichen Kaltkathodenfluoreszenzlampen (cold cathode fluorescence lamps - CCFL) mehrere Vorteile auf, wie längere Lebensdauer, potentielle Energieersparnis, Abwesenheit schädlicher Inhaltsstoffe (wie Quecksilber in CCFL).

An die Leuchtstoffe von LEDs werden hohe Anforderungen gestellt, diese müssen eine hohe und temperaturkonstante Effizienz aufweisen sowie chemisch stabil sein.
Leuchtstoffe der Zusammensetzung MLn₂QR₄O₁₂, wobei M für mindestens eines der Elemente Mg, Ca, Sr oder Ba steht, Ln für mindestens eines der Elemente Sc, Y, La, Ce, Pr, Nd, Sm, Eu, Gd, Tb, Dy, Ho, Er, Tm, Yb und Lu; Q für eines der Elemente Si, Ge, Sn, und Pb und R schließlich für mindestens eines der Elemente B, Al, Ga, In und Tl sind aus der US 2004/0062699 bekannt, z.B. BaY_{1,98}Ce_{0,02}SiAl₄O₁₂, SrY_{1,98}Ce_{0,02}SiAl₄O₁₂ und BaLu_{1,98}Ce_{0,02}SiAl₄O₁₂.

Aufgabe der vorliegenden Erfindung war es, Aluminat-Leuchtstoffe zu entwickeln, die eine höhere Lichteffizienz als bekannte Systeme aufweisen.

Überraschenderweise wurde nun gefunden, dass ein SrLu₂-Aluminat-Leuchtstoff gegenüber den oben genannten Leuchtstoffen eine höhere Lichteffizienz und zusätzlich auch eine höhere Temperaturstabilität (TQ₅₀) aufweist.

Eine erste Ausführungsform der vorliegenden Erfindung ist daher eine Verbindung der Formel I,

SrLu₂₋ₓSiAl₄O₁₂:Ceₓ (I)

wobei
x steht für einen Wert aus dem Bereich von 0,01 bis 0,15.

Vorzugsweise steht x für einen Wert aus dem Bereich 0,015 bis 0,12 und insbesondere bevorzugt aus dem Bereich 0,016 bis 0,10.

Erfindungsgemäße Leuchtstoffe in geringen Mengen eingesetzt ergeben bereits gute LED-Qualitäten. Die LED-Qualität wird dabei über übliche Parameter, wie beispielsweise den Color Rendering Index, den TQ₅₀-Wert sowie den Farbpunkt in CIE x und CIE y Koordinaten beschrieben.

Der Color Rendering Index oder CRI ist eine dem Fachmann geläufige, einheitslose lichttechnische Größe, welche die Farbwiedergabetreue einer künstlichen Lichtquelle mit derjenigen des Sonnenlichtes bzw. Filamentlichtquellen vergleicht (die beiden letztgenannten besitzen einen CRI von 100).

Der TQ₅₀-Wert ist die Temperatur, bei der das Emissionsspektrum eines Leuchtstoffs bzw. einer LED noch 50 % der Intensität aufweist, die es bei einer Temperatur von 0 °C hatte

CIE x und CIE y stehen für die Koordinaten im dem dem Fachmann geläufigen CIE Normfarbdiagramm (hier Normalbeobachter 1931), mit denen die Farbe einer Lichtquelle beschrieben wird.
Alle oben aufgeführten Größen werden nach dem Fachmann geläufigen Methoden aus Emissionsspektren der Lichtquelle berechnet.

Im Kontext dieser Anmeldung wird als grüne Emission oder grünes Licht solches Licht bezeichnet, dessen Intensitätsmaximum zwischen 508 und 550 nm Wellenlänge liegt, entsprechend wird als gelb solches Licht bezeichnet, dessen Maximum zwischen 551 und 585 nm Wellenlänge liegt und als rotes Licht, dessen Maximum zwischen 610 und 670 nm Wellenlänge liegt.

Ein weiterer Erfindungsgegenstand ist ein Verfahren zur Herstellung einer Verbindung der Formel I.
Hierzu werden in einem Schritt a) Lutetium-, Cer-, Aluminium-, Strontium- und Silicium-haltige Materialien gemischt und das Gemisch im Schritt b) noch mit mindestens einem weiteren anorganischen oder organischen Stoff versetzt und dann in einem Schritt c) thermisch nachbehandelt, vorzugsweise unter reduktiven Bedingungen.

Bei der oben genannten thermischen Behandlung ist es bevorzugt, wenn diese zumindest teilweise unter reduzierenden Bedingungen durchgeführt wird. Im Schritt b) erfolgt die Umsetzung üblicherweise bei einer Temperatur oberhalb 900 °C, vorzugsweise bei einer Temperatur oberhalb 1000°C und insbesondere bevorzugt im Bereich von 1100°C - 1500°C. Die reduktiven Bedingungen werden dabei z.B. mit Kohlenmonoxid, Formiergas oder Wasserstoff oder zumindest Vakuum oder Sauerstoffmangel-Atmosphäre eingestellt, bevorzugt im Argonstrom, vorzugsweise im Ar/H₂-Strom und insbesondere bevorzugt im Ar/H₂ -Strom (90 - 70 : 10 - 30) eingestellt. Außerdem kann die thermische Nachbehandlung ein- oder mehrstufig durchgeführt werden, wobei mehrstufig, insbesondere zweistufig, bevorzugt ist.

Als anorganischen oder organischen Stoff (im Schritt b) wird ein Stoff aus der Gruppe der Ammoniumhalogenide, vorzugsweise Ammoniumchlorid, Erdalkalifluoride wie Calcium-, Strontium- oder Bariumfluorid, Borate,

Borsäure, Carbonate, vorzugsweise Ammoniumhydrogencarbonat, Alkoholate wie Oxalate und/oder Kieselsäure wie Tetraethylorthosilikat (TEOS) eingesetzt.
Die Herstellung der erfindungsgemäßen Leuchtstoffe kann entweder nasschemisch oder über Festkörperdiffusionsmethode (engl. mixing and firing) erfolgen, wobei die nasschemischen Verfahren aus anorganischen und/oder organischen Metall- und/oder Seltenerd-Salzen mittels Sol-Gel-Verfahren, Copräzipitations- und/oder Trocknungsverfahren, vorzugsweise Sprühtrocknung, bevorzugt sind.

Die nasschemische Herstellung besitzt gegenüber der herkömmlichen Festkörperdiffusions-Methode generell den Vorteil, dass die resultierenden Materialien eine höhere Einheitlichkeit in Bezug auf die stöchiometrische Zusammensetzung, die Partikelgröße und die Morphologie der Partikel aufweisen, aus denen der erfindungsgemäße Leuchtstoff hergestellt wird.

Für die nasschemische Vorbehandlung einer wässrigen Vorstufe der Leuchtstoffe (Leuchtstoffprecursoren) bestehend z.B. aus einem Gemisch von Lutetiumchlorid-, Cerchlorid-, Aluminiumchlorid-, Strontiumchlorid-, Tetraethylorthosilikat- und Ammoniumhydrogencarbonat-Lösung sind folgende bekannte Methoden bevorzugt:
- Cofällung (auch Copräzipitation genannt) mit einer NH₄HCO₃-Lösung *(siehe z.B.* Jander, Blasius Lehrbuch der analyt. u. präp. anorg. Chem. 2002*)*
- Pecchini-Verfahren mit einer Lösung aus Zitronensäure und Ethylenglykol *(siehe z.B.* Annual Review of Materials Research Vol. 36: 2006, 281-331*)*
- Combustion-Verfahren unter Verwendung von Harnstoff
- Sprühtrocknung wässriger oder organischer Salzlösungen (Edukte)
- Sprühpyrolyse (auch Spraypyrolyse genannt) wässriger oder organischer Salzlösungen (Edukte)
- Eindampfen von Nitratlösungen und thermischer Umsetzung des Rückstandes

Bei der o.g. Cofällung werden z.B. Chloridlösungen der entsprechenden Leuchtstoffedukte mit einer TEOS/NH₄HCO₃-Lösung versetzt, wodurch sich der Leuchtstoffprecursor bildet, der anschließend durch eine ein- oder mehrstufige thermische Behandlung in den Leuchtstoff umgewandelt wird. Diese Methode ist erfindungsgemäß besonders bevorzugt.

Beim Pecchini-Verfahren werden z.B. Nitratlösungen der entsprechenden Leuchtstoffedukte bei Raumtemperatur mit einem Fällungsreagenz bestehend aus Zitronensäure und Ethylenglykol versetzt und anschließend erhitzt. Durch Erhöhung der Viskosität kommt es zur Leuchtstoffprecursor-Bildung.

Beim bekannten Combustion-Verfahren werden z.B. Nitratlösungen der entsprechenden Leuchtstoffedukte in Wasser gelöst, dann unter Rückfluss gekocht und mit Harnstoff versetzt, wodurch sich der Leuchtstoffprecursor langsam bildet.

Die Sprühpyrolyse gehört zu den Aerosolverfahren, die durch Versprühen von Lösungen, Suspensionen oder Dispersionen in einen durch unterschiedliche Art und Weise erhitzten Reaktionsraum (Reaktor) sowie die Bildung und Abscheidung von Feststoff- Partikeln gekennzeichnet sind. Im Gegensatz zur Sprühtrocknung mit Heißgastemperaturen < 200°C finden bei der Sprühpyrolyse als Hochtemperatur- Prozess außer der Verdampfung des Lösungsmittels zusätzlich die thermische Zersetzung der verwendeten Edukte (z. B. Salze) sowie die Neubildung von Stoffen (z. B. Oxide, Mischoxide) statt.

Die o.g. 6 Verfahrensvarianten sind ausführlich in der WO2007/144060 (Merck) beschrieben, die voll umfänglich in den Kontext der vorliegenden Anmeldung durch Bezugnahme eingefügt wird.

Die erfindungsgemäßen grün-emittierenden Leuchtstoffe können mit rot-emittierenden Leuchtstoffen gemischt werden, wodurch sich solche Mischungen hervorragend für Anwendungen in der Allgemeinbeleuchtung und LCD-backlighting eignen.

Eine weitere Ausführungsform der vorliegenden Erfindung ist daher eine Mischung enthaltend mindestens eine Verbindung der Formel I und mindestens einen rot-emittierenden Leuchtstoff, wobei dieser vorzugsweise ausgewählt wird aus Ce-dotierten Granaten, Eu-dotierten Thiogallaten, Eu-dotierten Sulfoseleniden und Eu- und/oder Ce-dotierten Nitriden, Oxynitriden, Alumonitriden und/oder Mn(IV) dotierten Oxiden und/oder Fluoriden. Dabei kann es insbesondere bevorzugt sein, wenn der rot-emittierende Leuchtstoff ausgewählt ist aus den nitridischen Leuchtstoffen, vorzugsweise (Ca,Sr,Ba)₂Si₅N₈:Eu, (Ca,Sr)AlSiN₃:Eu, (Ca,Sr;Ba)SiN₂:Eu, (Ca,Sr,Ba)₆Si₃O₆N₄:Eu, (A_{2-0,5y-x} Euₓ Si₅ N_{8-y} Oy , wobei A steht für ein oder mehrere Elemente ausgewählt aus Ca, Sr, Ba und x steht für einen Wert aus dem Bereich von 0,005 bis 1 und y steht für einen Wert aus dem Bereich von 0,01 bis 3 oder Varianten der genannten Verbindungen, bei denen einzelne Gitterpositionen durch andere chemische Elemente, wie Alkalimetalle, Aluminium, Gallium, oder Gadolinium, substituiert sind bzw. solche weiteren Elemente als Dotierstoff Fehlstellen besetzen. Dem Fachmann bekannte und geeignete Materialsysteme stellen Siliconitride und Alumosilikonitride dar (vgl. Xie, Sci. Technol. Adv. Mater. 2007, 8, 588-600): 1-1-2-Nitride, wie z.B. das CaSiN₂:Eu²⁺ (Le Toquin, Cheetham, Chem. Phys. Lett. 2006, 423, 352.), 2-5-8-Nitride, wie das (Ca,Sr,Ba)₂Si₅N₈:Eu²⁺ (Li et al., Chem. Mater. 2005, 15, 4492) und Alumosiliconitride, wie das (Ca,Sr)AlSiN₃:Eu²⁺ (K. Uheda et al., Electrochem. Solid State Lett. 2006, 9, H22).

Die Verbindung A_{2-0,5y-x} Euₓ Si₅ N_{8-y} O_{y}, wobei A steht für ein oder mehrere Elemente ausgewählt aus Ca, Sr, Ba und x steht für einen Wert aus dem Bereich von 0,005 bis 1 und y steht für einen Wert aus dem Bereich von 0,01 bis 3 ist in der Patentanmeldung EP10000933.1 beschrieben und wird im folgenden Verbindung der Formel II genannt. Dabei kann die Verbindung als Reinstoff oder im Gemisch mit mindestens einer weiteren Silicium und Sauerstoff enthaltenden Verbindung vorliegen, wobei es bevorzugt ist, wenn die mindestens eine weitere Silicium und Sauerstoff enthaltende Verbindung ein Reaktionsnebenprodukt der Herstellung der Verbindung der Formel II ist und diese die anwendungsreleventen optischen Eigenschaften der Verbindung der Formel II nicht nachteilig beeinflusst. Daher ist eine Mischung enthaltend eine Verbindung der Formel II, die erhältlich ist durch ein Verfahren, bei dem in einem Schritt a) geeignete Edukte ausgewählt aus binären Nitriden, Halogeniden und Oxiden oder entsprechenden reaktiven Formen dazu gemischt werden und das Gemisch in einem Schritt b) unter reduktiven Bedingungen thermisch behandelt wird ein weiterer Erfindungsgegenstand.
In den erfindungsgemäßen Verbindungen der Formel II steht A in bevorzugten Ausführungsformen für Sr, während x in bevorzugten Ausführungsformen steht für einen Wert aus dem Bereich von 0,01 bis 0,8, vorzugsweise aus dem Bereich 0,02 bis 0,7 und insbesondere bevorzugt aus dem Bereich 0,05 bis 0,6 und insbesondere bevorzugt aus dem Bereich 0,1 bis 0,4 und y in bevorzugten Ausführungsformen steht für einen Wert aus dem Bereich von 0,1 bis 2,5, vorzugsweise aus dem Bereich 0,2 bis 2 und insbesondere bevorzugt aus dem Bereich 0,22 bis 1,8.
Zur Herstellung von Leuchtstoffen der Formel II werden in einem Schritt a) geeignete Edukte ausgewählt aus binären Nitriden, Halogeniden und Oxiden oder entsprechenden reaktiven Formen dazu gemischt und das Gemisch in einem Schritt b) unter reduktiven Bedingungen thermisch behandelt. Bei der oben genannten thermischen Behandlung ist es bevorzugt, wenn diese zumindest teilweise unter reduzierenden Bedingungen durchgeführt wird. Im Schritt b) erfolgt die Umsetzung üblicherweise bei einer Temperatur oberhalb 800 C, vorzugsweise bei einer Temperatur oberhalb 1200°C und insbesondere bevorzugt im Bereich von 1400°C - 1800°C. Die reduktiven Bedingungen werden dabei z.B. mit Kohlenmonoxid, Formiergas oder Wasserstoff oder zumindest Vakuum oder Sauerstoffmangel-Atmosphäre eingestellt, bevorzugt im Stickstoffstrom, vorzugsweise im N2/H2-Strom und insbesondere bevorzugt im N2/H2/NH3-Strom eingestellt. Soll die Verbindungen der Formel II rein hergestellt werden, so kann dies entweder über genaue Kontrolle der Eduktstöchiometrie oder durch mechanisches Abtrennen der Kristalle der Verbindungen der Formel II von den glasartigen Anteilen erfolgen. Die Abtrennung kann beispielsweise über die unterschiedliche Dichte, Partikelform oder Partikelgröße nach dem Fachmann bekannten Trennmethoden erfolgen.

Dabei liegen erfindungsgemäß die Verbindung (bzw. Leuchtstoff) gemäß Formel I und der mindestens eine rot emittierende Leuchtstoff üblicherweise im Gewichtsverhältnis 20:1 bis 1:1 vor. Erfindungsgemäß bevorzugt ist es, wenn der mindestens eine Leuchtstoff der Formel I und der mindestens eine rot emittierende Leuchtstoff im Gewichtsverhältnis 10:1 bis 3:1 und insbesondere bevorzugt 6:1 bis 4:1 vorliegen.

Ein weiterer Erfindungsgegenstand ist ein Verfahren zur Herstellung einer Leuchtstoffmischung bei dem mindestens einer Verbindung (bzw. Leuchtstoff) der Formel I mit mindestens einem rot emittierenden Leuchtstoff gemischt wird.

Die Partikelgröße der erfindungsgemäßen Leuchtstoffe beträgt üblicherweise zwischen 50 nm und 30 µm, vorzugsweise zwischen 1 µm und 20 µm.

In einer weiteren bevorzugten Ausführungsform besitzen die Leuchtstoffe in Partikelform eine geschlossene Oberflächenbeschichtung, die aus SiO₂, TiO₂, Al₂O₃, ZnO, ZrO₂ und/oder Y₂O₃ oder Mischoxide daraus besteht. Diese Oberflächenbeschichtung hat den Vorteil, dass durch eine geeignete Abstufung der Brechungsindices der Beschichtungsmaterialien eine Anpassung des Brechungsindex mit der Umgebung erzielt werden kann. In diesem Fall wird die Streuung des Lichtes an der Oberfläche des Leuchtstoffes verringert und ein größerer Anteil des Lichtes kann in den Leuchtstoff eindringen und dort absorbiert und konvertiert werden. Außerdem ermöglicht es die Brechungsindex-angepasste Oberflächebeschichtung, dass mehr Licht aus dem Leuchtstoff ausgekoppelt wird, weil die interne Totalreflexion verringert wird.

Zudem ist eine geschlossene Schicht dann vorteilhaft, wenn der Leuchtstoff verkapselt werden muss. Dies kann erforderlich sein, um einer Empfindlichkeit des Leuchtstoffes oder Teilen davon gegen diffundierendes Wasser oder andere Materialien in der unmittelbaren Umgebung zu entgegnen. Ein weiterer Grund für die Verkapselung mit einer geschlossenen Hülle ist eine thermische Entkoppelung des eigentlichen Leuchtstoffes von der Wärme, die im Chip entsteht. Diese Wärme führt zu einer Verringerung der Fluoreszenzlichtausbeute des Leuchtstoffes und kann auch die Farbe des Fluoreszenzlichts beeinflussen. Schließlich ist es möglich durch eine solche Beschichtung die Effizienz des Leuchtstoffes zu erhöhen, indem im Leuchtstoff entstehende Gitterschwingungen in ihrer Ausbreitung an die Umgebung gehindert werden.

Außerdem bevorzugt ist es, wenn die Leuchtstoffe eine poröse Oberflächenbeschichtung besitzen, die aus SiO₂, TiO₂, Al₂O₃, ZnO, ZrO₂ und/oder Y₂O₃ oder Mischoxide daraus oder aus der Leuchtstoffzusammensetzung besteht. Diese porösen Beschichtungen bieten die Möglichkeit, den Brechungsindex einer Einfachschicht weiter zu reduzieren. Die Herstellung solcher poröser Beschichtungen kann nach drei herkömmlichen Methoden geschehen, wie sie in WO 03/027015 beschrieben werden, die voll umfänglich in den Kontext der vorliegenden Anmeldung durch Bezugnahme eingefügt wird: das Ätzen von Glas (z.B. Natron-Kalk-Gläser (siehe US 4019884)), das Aufbringen einer porösen Schicht und die Kombination aus poröser Schicht und einem Ätzvorgang.

In einer weiteren bevorzugten Ausführungsform besitzen die Leuchtstoffpartikel eine Oberfläche, die funktionelle Gruppen trägt, welche eine chemische Anbindung an die Umgebung, vorzugsweise bestehend aus Epoxy- oder Silikonharz ermöglicht. Diese funktionellen Gruppen können z.B. über Oxogruppen angebundene Ester oder andere Derivate sein, die mit Bestandteilen der Bindemittel auf Basis von Epoxiden und / oder Silikonen Verknüpfungen eingehen können. Solche Oberflächen haben den Vorteil, dass eine homogene Einmischung der Leuchtstoffe in das Bindemittel ermöglicht wird. Des Weiteren können dadurch die rheologischen Eigenschaften des Systems Leuchtstoff / Bindemittel und auch die Topfzeiten in einem gewissen Masse eingestellt werden. Damit wird die Verarbeitung der Gemische vereinfacht.

Da die auf dem LED Chip aufgebrachte erfindungsgemäße Leuchtstoffschicht vorzugsweise aus einem Gemisch von Silikon und homogenen Leuchtstoffpartikeln besteht, welches im Volumenguss aufgebracht wird, und das Silikon eine Oberflächenspannung aufweist, ist diese Leuchtstoffschicht auf mikroskopischer Ebene nicht einheitlich bzw. ist die Dicke der Schicht nicht durchweg konstant. Dies ist in der Regel auch der Fall wenn der Leuchtstoff nicht nach dem Volumengussverfahren, sondern im sogenannten Chip-Level-Konversionsverfahren, bei dem eine hochkonzentrierte, dünne Leuchtstoffschicht mit Hilfe von elektrostatischen Methoden direkt auf die Oberfläche des Chips appliziert wird, aufgebracht wird.

Mit Hilfe des o.g. Verfahren können beliebige äußere Formen der Leuchtstoffpartikel hergestellt werden, wie sphärische Partikel, Plättchen und strukturierte Materialien und Keramiken.

Die Herstellung von plättchenförmigen Leuchtstoffen als weitere bevorzugte Ausführungsform geschieht nach herkömmlichen Verfahren aus den entsprechenden Metall- und/oder Seltenerd-Salzen. Das Herstellverfahren ist in EP 763573 und DE 102006054331 ausführlich beschrieben, welche voll umfänglich in den Kontext der vorliegenden Anmeldung durch Bezugnahme eingefügt werden. Diese plättchenförmigen Leuchtstoffe können hergestellt werden, indem ein natürlicher oder synthetisch hergestellter hoch stabiler Träger bzw. ein Substrat aus beispielsweise Glimmer-, SiO₂-, Al₂O₃-, ZrO₂, Glas- oder TiO₂-Plättchen, welches ein sehr großes Aspektverhältnis aufweist, eine atomar glatte Oberfläche und eine einstellbare Dicke besitzt, durch Fällungsreaktion in wässriger Dispersion oder Suspension mit einer Leuchtstoffschicht beschichtet werden kann. Neben Glimmer, ZrO₂, SiO₂, Al₂O₃, Glas oder TiO₂ oder Gemischen derselben können die Plättchen auch aus dem Leuchtstoffmaterial selbst bestehen, oder aus einem Material aufgebaut sein. Falls das Plättchen selbst lediglich als Träger für die Leuchtstoffbeschichtung dient, muss diese aus einem Material bestehen, welches transparent für die Primärstrahlung der LED ist, oder die Primärstrahlung absorbiert und diese Energie auf die Leuchtstoffschicht überträgt. Die plättchenförmigen Leuchtstoffe werden in einem Harz (z.B. Silikon- oder Epoxidharz), dispergiert und diese Dispersion wird auf dem LED Chip aufgebracht.

Die plättchenförmigen Leuchtstoffe können in Dicken von 50 nm bis zu etwa 20 µm, vorzugsweise zwischen 150 nm und 5 µm, grosstechnisch hergestellt werden. Der Durchmesser beträgt dabei von 50 nm bis 20 µm. Er besitzt in der Regel ein Aspektverhältnis (Verhältnis des Durchmessers zur Teilchendicke) von 1: 1 bis 400 : 1, und insbesondere 3 : 1 bis 100 : 1. Die Plättchenausdehnung (Länge x Breite) ist von der Anordnung abhängig. Plättchen eignen sich auch als Streuzentren innerhalb der Konversionsschicht, insbesondere dann, wenn sie besonders kleine Abmessungen aufweisen.
Die dem LED Chip zugewandte Oberfläche des erfindungsgemäßen plättchenförmigen Leuchtstoffes kann mit einer Beschichtung versehen werden, welche entspiegelnd in Bezug auf die von dem LED Chip emittierte Primärstrahlung wirkt. Dies führt zu einer Verringerung der Rückstreuung der Primärstrahlung, wodurch diese besser in den erfindungsgemäßen Leuchtstoffkörper eingekoppelt werden kann.
Hierfür eignen sich beispielsweise brechzahlangepasste Beschichtungen, die eine folgende Dicke d aufweisen müssen: d = [Wellenlänge der Primärstrahlung des LED Chips /(4* Brechzahl der Leuchtstoffkeramik)], s. beispielsweise Gerthsen, Physik, Springer Verlag, 18. Auflage, 1995. Diese Beschichtung kann auch aus photonischen Kristallen bestehen. Wobei hierunter auch eine Strukturierung der Oberfläche des plättchenförmigen Leuchtstoffes fällt, um bestimmte Funktionalitäten zu erreichen.

Die Herstellung der erfindungsgemäßen Leuchtstoffe in Form von keramischen Körpern erfolgt analog nach dem in der DE 102006037730 (Merck) beschriebenen Verfahren, die voll umfänglich in den Kontext der vorliegenden Anmeldung durch Bezugnahme eingefügt wird. Dabei wird der Leuchtstoff durch Mischen der entsprechenden Edukte und Dotierstoffe nasschemisch hergestellt, anschließend isostatisch verpresst und in Form eines homogenen dünnen und nicht porösen Plättchens direkt auf die Oberfläche des Chips aufgebracht. Somit findet keine ortsabhängige Variation der Anregung und Emission des Leuchtstoffes statt, wodurch die damit ausgerüstete LED einen homogenen und farbkonstanten Lichtkegel emittiert und über eine hohe Lichtleistung verfügt. Die keramischen Leuchtstoffkörper können z.B. als Plättchen in Dicken von einigen 100 nm bis zu etwa 500 µm großtechnisch hergestellt werden. Die Plättchenausdehnung (Länge x Breite) ist von der Anordnung abhängig. Bei direkter Aufbringung auf den Chip ist die Größe des Plättchens gemäß der Chipausdehnung (von ca. 100 µm * 100 µm bis zu mehreren mm²) mit einem gewissen Übermaß von ca. 10% - zu 30% der Chipoberfläche bei geeigneter Chipanordnung (z.B. Flip-Chip-Anordnung) oder entsprechend zu wählen. Wird das Leuchtstoffplättchen über einer fertigen LED angebracht, so ist der austretende Lichtkegel vollständig vom Plättchen zu erfassen.

Die Seitenflächen des keramischen Leuchtstoffkörpers können mit einem Leicht- oder Edelmetall, vorzugsweise Aluminium oder Silber verspiegelt werden. Die Verspiegelung bewirkt, dass kein Licht lateral aus dem Leuchtstoffkörper austritt. Lateral austretendes Licht kann den aus der LED auszukoppelnden Lichtstrom verringern. Die Verspiegelung des keramischen Leuchtstoffkörpers erfolgt in einem Prozessschritt nach der isostatischen Verpressung zu Stangen oder Plättchen, wobei vor der Verspiegelung eventuell ein Schneider der Stangen oder Plättchen in die erforderliche Größe erfolgen kann. Die Seitenflächen werden hierzu z.B. mit einer Lösung aus Silbernitrat und Glucose benetzt und anschließend bei erhöhter Temperatur einer Ammoniak-Atmosphäre ausgesetzt. Hierbei bildet sich z.B. ein silberner Belag auf den Seitenflächen aus.
Alternativ bieten sich auch stromlose Metallisierungsverfahren an, siehe beispielsweise Hollemann-Wiberg, Lehrbuch der Anorganischen Chemie, Walter de Gruyter Verlag oder Ullmanns Enzyklopädie der chemischen Technologie.
Der keramische Leuchtstoffkörper kann, falls erforderlich, mit einer Wasserglaslösung auf dem Untergrund eines LED Chip fixiert werden.

In einer weiteren Ausführungsform besitzt der keramische Leuchtstoffkörper auf der, einem LED Chip entgegengesetzten Seite eine strukturierte (z.B. pyramidale) Oberfläche. Somit kann möglichst viel Licht aus dem Leuchtstoffkörper ausgekoppelt werden. Die strukturierte Oberfläche auf dem Leuchtstoffkörper wird dadurch hergestellt, in dem beim isostatischen Verpressen das Presswerkzeug eine strukturierte Pressplatte aufweist und dadurch eine Struktur in die Oberfläche prägt. Strukturierte Oberflächen sind dann gewünscht, wenn möglichst dünne Leuchtstoffkörper bzw. Plättchen hergestellt werden sollen. Die Pressbedingungen sind dem Fachmann bekannt (siehe J. Kriegsmann, Technische keramische Werkstoffe, Kap. 4, Deutscher Wirtschaftsdienst, 1998). Wichtig ist, dass als Presstemperaturen 2/3 bis zu 5/6 der Schmelztemperatur des zu verpressenden Stoffes verwendet werden.

Die Anregbarkeit der erfindungsgemäßen Leuchtstoffe erstrecken sich zudem über einen weiten Bereich, der von etwa 410 nm bis 530 nm, bevorzugt 430 nm bis zu etwa 500 nm reicht. Damit sind diese Leuchtstoffe nicht nur zur Anregung durch UV oder blau emittierende Lichtquellen wie LEDs oder konventionelle Entladungslampen (z.B. auf Hg-Basis) geeignet, sondern auch für Lichtquellen wie solche, welche die blaue In³⁺ -Linie bei 451 nm ausnutzen.

Ein weiterer Gegenstand der vorliegenden Erfindung ist eine Lichtquelle dadurch gekennzeichnet, dass diese einen Halbleiter und mindestens einen Leuchtstoff nach Formel I sowie mindestens einen rot emittierenden Leuchtstoff enthält. Vorzugsweise ist diese Beleuchtungseinheit weiß emittierend oder emittiert Licht mit einem bestimmten Farbpunkt (Color-on-demand-Prinzip).

Ein weiterer Gegenstand der vorliegenden Erfindung ist eine Lichtquelle, dadurch gekennzeichnet, dass diese einen Halbleiter und mindestens einen Leuchtstoff nach Formel I enthält.

Unter dem color-on-demand Konzept versteht man die Realisierung von Licht eines bestimmten Farbpunktes mit einer pcLED (= phosphor converted LED) unter Einsatz eines oder mehrer Leuchtstoffe. Dieses Konzept wird z.B. verwendet, um bestimmte Corporate Designs, z.B. für beleuchtete Firmenlogos, Marken etc. zu erzeugen.

In einer bevorzugten Ausführungsform der erfindungsgemäßen Lichtquelle handelt es sich bei dem Halbleiter um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 ist.

In einer weiteren bevorzugten Ausführungsform der erfindungsgemäßen Lichtquelle handelt es sich bei der Lichtquelle um eine lumineszente auf ZnO, TCO (Transparent conducting oxide), ZnSe oder SiC basierende Anordnung oder auch um eine auf einer organischen lichtemittierende Schicht basierende Anordnung (OLED).

In einer weiteren bevorzugten Ausführungsform der erfindungsgemäßen Lichtquelle handelt es sich bei der Lichtquelle um eine Quelle, die Elektrolumineszenz und/oder Photolumineszenz zeigt. Weiterhin kann es sich bei der Lichtquelle auch um eine Plasma- oder Entladungsquelle handeln.

Dem Fachmann sind mögliche Formen von derartigen Lichtquellen bekannt. Es kann sich hierbei um lichtemittierende LED-Chips unterschiedlichen Aufbaus handeln.

Die erfindungsgemäßen Leuchtstoffe können entweder in einem Harz dispergiert (z.B. Epoxy- oder Siliconharz), oder bei geeigneten Größenverhältnissen direkt auf der Lichtquelle angeordnet werden oder aber von dieser, je nach Anwendung, entfernt angeordnet sein (letztere Anordnung schließt auch die "Remote phosphor Technologie" mit ein). Die Vorteile der "Remote phosphor Technologie" sind dem Fachmann bekannt und z.B. der folgenden Publikation zu entnehmen: Japanese Journ. of Appl. Phys. Vol. 44, No. 21 (2005). L649-L651.

Weitere Erfindungsgegenstände sind eine Beleuchtungseinheit, insbesondere zur Hintergrundbeleuchtung von Anzeigevorrichtungen, die dadurch gekennzeichnet ist, dass sie mindestens eine oben beschriebene Lichtquelle enthält und entsprechende Anzeigevorrichtungen, insbesondere Flüssigkristallanzeigevorrichtung (LC Display), mit einer Hintergrundbeleuchtung, die dadurch gekennzeichnet sind, dass sie mindestens eine solche Beleuchtungseinheit enthalten.

Weiterhin bevorzugt ist eine Beleuchtungseinheit, insbesondere zur Allgemeinbeleuchtung, die dadurch gekennzeichnet ist, dass sie einen CRI (=color rendering index) > 60, vorzugsweise > 70, noch bevorzugter >80 aufweist. CRI-Werte > 80 können allerdings nur realisiert werden, wenn der erfindungsgemäße grüne Leuchtstoff zusätzlich mit roten Leuchtstoffen in der LED kombiniert wird.

In einer weiteren Ausführungsform ist es bevorzugt, wenn die optische Ankopplung der Beleuchtungseinheit zwischen dem Leuchtstoff und der Lichtquelle durch eine lichtleitende Anordnung realisiert wird.
Dadurch ist es möglich, dass an einem zentralen Ort die Lichtquelle installiert wird und diese mittels lichtleitender Vorrichtungen, wie beispielsweise lichtleitenden Fasern, an den Leuchtstoff optisch angekoppelt ist. Auf diese Weise lassen sich den Beleuchtungswünschen angepasste Leuchten lediglich bestehend aus einem oder unterschiedlichen Leuchtstoffen, die zu einem Leuchtschirm angeordnet sein können, und einem Lichtleiter, der an die Lichtquelle angekoppelt ist, realisieren. Auf diese Weise ist es möglich, eine starke Lichtquelle an einen für die elektrische Installation günstigen Ort zu platzieren und ohne weitere elektrische Verkabelung, sondern nur durch Verlegen von Lichtleitern an beliebigen Orten Leuchten aus Leuchtstoffen, welche an die Lichtleiter gekoppelt sind, zu installieren.

Ein weiterer Gegenstand der vorliegenden Erfindung ist die Verwendung der erfindungsgemäßen Leuchtstoffe zur teilweisen oder vollständigen Konversion der blauen oder im nahen UV-liegenden Emission einer Lumineszenzdiode.

Weiterhin bevorzugt ist die Verwendung der erfindungsgemäßen Leuchtstoffe zur Konversion der blauen oder im nahen UV-liegenden Emission in sichtbare weiße Strahlung. Weiterhin ist die Verwendung der erfindungsgemäßen Leuchtstoffe zur Konversion der Primärstrahlung in einen bestimmten Farbpunkt nach dem "Color on demand"-Konzept bevorzugt.

Ein weiterer Gegenstand der vorliegenden Erfindung ist die Verwendung der erfindungsgemäßen Leuchtstoffe in Elektrolumineszenz-Materialien, wie beispielsweise Elektrolumineszenz-Folien (auch Leuchtfolien oder Lichtfolien genannt), in denen beispielsweise Zinksulfid oder Zinksulfid dotiert mit Mn²⁺, Cu⁺, oder Ag⁺ als Emitter eingesetzt wird, die im gelbgrünen Bereich emittieren. Die Anwendungsbereiche der Elektrolumineszenz-Folie sind z.B. Werbung, Displayhintergrundbeleuchtung in Flüssigkristallbildschirmen (LC-Displays) und Dünnschichttransistor-Displays (TFT-Displays), selbstleuchtende KFZ-Kennzeichenschilder, Bodengrafik (in Verbindung mit einem tritt- und rutschfesten Laminat), in Anzeigen- und/oder Bedienelementen beispielsweise in Automobilen, Zügen, Schiffen und Flugzeugen oder auch Haushalts-, Garten-, Mess- oder Sport- und Freizeitgeräten.

Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die zugegebenen Mengen der Komponenten in den Zusammensetzungen immer zu insgesamt 100% addieren. Gegebene Prozentangaben sind immer im gegebenen Zusammenhang zu sehen. Sie beziehen sich üblicherweise aber immer auf die Masse der angegebenen Teil- oder Gesamtmenge.

Auch ohne weitere Ausführungen wird davon ausgegangen, dass ein Fachmann die obige Beschreibung in weitestem Umfang nutzen kann. Die bevorzugten Ausführungsformen sind deswegen lediglich als beschreibende, keinesfalls als in irgendeiner Weise limitierende Offenbarung aufzufassen. Die vollständige Offenbarung aller vor- und nachstehend aufgeführten Anmeldungen und Veröffentlichungen sind durch Bezugnahme in diese Anmeldung eingeführt. Die folgenden Beispiele sollen die vorliegende Erfindung verdeutlichen. Sie sind jedoch keinesfalls als limitierend zu betrachten. Alle Verbindungen oder Komponenten, die in den Zubereitungen verwendet werden können, sind entweder bekannt und käuflich erhältlich oder können nach bekannten Methoden synthetisiert werden.

### Beispiele

### Beispiel 1: Herstellung von SrLu_{1,98}Ce_{0,02}SiAl₄O₂ über eine Hydrogencarbonatfällung

227ml Ethanol, 85ml VE-Wasser und 34ml Tetraethylorthosilikat werden vorgelegt und 53ml Ammoniaklösung (25%) werden innerhalb von 30 s zugegeben. Es wird 30 Min. nachgerührt bei pH 11,9, wobei eine milchige Suspension entsteht.
Innerhalb 5 Min. wird durch Zugabe von 60,1g Salzsäure (25%) ein pH 7 eingestellt. 537,6g Ammoniumhydrogencarbonat werden unter Erwärmen in 3000ml VE-Wasser gelöst und zur SiO₂-Suspension gegeben.
129,8g Lutetiumchlorid Hexahydrat, 2,53g Cerchlorid Heptahydrat, 164,2g Aluminiumchlorid Hexahydrat und 45,3g Strontiumchlorid-Hexahydrat werden in 600ml VE-Wasser gelöst. Die entstehende Lösung wird innerhalb von 45 Min. zur Hydrogencarbonat-SiO₂-Suspension zugetropft und 30 Min. nachgerührt. Der Feststoff wird abgesaugt und im Trockenschrank bei 120°C getrocknet.
Der so erhaltene Precursor wird 4 Stunden bei 1100°C unter Laboratmosphäre vorkalziniert.
Ausbeute: 125g hellgelbes Pulver

Der vorkalzinierte Precursor wird 4h bei 1400°C unter 80%Ar/20%H₂ HTgeglüht. Nach der Abkühlung wird der Leuchtstoff gemahlen und über ein 20µ-Sieb klassiert.

### Beispiel 2: Herstellung von SrLu_{1,98}Ce_{0,02}SiAl₄O₁₂ über eine Festkörperdiffusionsreaktion (mix & fire)

66,29g Lutetiumoxid, 1,17g Cerdioxid, 34,66g Aluminiumoxid, 25,09g Strontiumcarbonat, 10,21g Siliciumdioxid und 10 g Ammoniumchlorid werden in einer PE-Flasche eingewogen. Die Flasche wird verschraubt und das Gemisch 8 Stunden auf einer Rollenbank homogenisiert.
Der so erhaltene Precursor wird 4 Stunden bei 1100°C unter Laboratmosphäre vorkalziniert. Danach wird der vorkalzinierte Precursor 4h bei1400°C unter 80%Ar/20%H₂ geglüht. Nach der Abkühlung wird der Leuchtstoff gemahlen und über ein 20µ-Sieb klassiert.

### Darstellung von nitridischen Leuchtstoffen für Mischungen

### Beispiel 3A: Herstellung von Sr_{1,8}Si₅N_{7,6}O_{0,4}:Eu

13,96 g Sr₃N₂, 0,996 g EuN und 4,512 g Siliciumdioxid werden in einer mit Stickstoff gefüllten Glovebox eingewogen und vermischt. Das entstandene Gemisch wird in einen Molybdäntiegel gefüllt und in einen Rohrofen überführt. Anschließend wird das Gemisch 8 Stunden bei 1600 °C unter einer Stickstoff/Wasserstoffatmosphäre kalziniert. Nach Abkühlung wird der Rohleuchtstoff entnommen, kurz gemörsert und erneut in einen Molybdäntiegel gefüllt, der dann in einen Hochdruckofen überführt wird. In diesem wird der Leuchtstoff erneut 8 Stunden bei 1600 °C unter einem Stickstoffdruck von 65 bar kalziniert.
Nach Abkühlung wird der Leuchtstoff entnommen und in 100 ml 1 molarer Salzsäure suspendiert. Die entstehende Suspension wird 3 Stunden gerührt, anschließend wird der Rührer ausgeschaltet. Nach einigen Minuten wird der Überstand abgegossen, der verbleibende Rückstand wird erneut in VE-Wasser aufgenommen, abgenutscht, mit VE-Wasser neutral gewaschen und getrocknet.

### Beispiel 3B: Herstellung von Sr₂Si₅N_{7,666}O_{0,5}:Eu

17,84 g Sr₃N₂, 2,655 g EuN und 22,21 g Siliciumnitrid und 1,502 Siliciumdioxid werden in einer mit Stickstoff gefüllten Glovebox eingewogen und vermischt. Das entstandene Gemisch wird in einen Molybdäntiegel gefüllt und in einen Rohrofen überführt. Anschließend wird das Gemisch 8 Stunden bei 1600 °C unter einer Stickstoff/Wasserstoffatmosphäre kalziniert. Nach Abkühlung wird der Rohleuchtstoff entnommen, kurz gemörsert und erneut in einen Molybdäntiegel gefüllt, der dann in einen Hochdruckofen überführt wird. In diesem wird der Leuchtstoff erneut 8 Stunden bei 1600 °C unter einem Stickstoffdruck von 65 bar kalziniert. Nach Abkühlung wird der Leuchtstoff entnommen und in 100 ml VE-Wasser suspendiert. Die entstehende Suspension wird 30 Minuten gerührt, anschließend wird der Rührer ausgeschaltet. Nach einigen Minuten wird der Überstand abgegossen, der verbleibende Rückstand wird erneut in VE-Wasser aufgenommen, abgenutscht, mit VE-Wasser neutral gewaschen und getrocknet.

### Beispiel 3C: Herstellung des Leuchtstoffs Sr₂Si₅N₈:Eu

1,84 g Sr₃N₂, 0,166 g EuN und 2,33 g Siliciumnitrid werden in einer mit Stickstoff gefüllten Glovebox eingewogen und vermischt. Das entstandene Gemisch wird in einen Molybdäntiegel gefüllt und in einen Rohrofen überführt. Anschließend wird das Gemisch 8 Stunden bei 1600 °C unter einer Stickstoff/Wasserstoffatmosphäre kalziniert. Nach Abkühlung wird der Rohleuchtstoff entnommen, kurz gemörsert und erneut in einen Molybdäntiegel gefüllt, der dann in einen Hochdruckofen überführt wird. In diesem wird der Leuchtstoff erneut 8 Stunden bei 1600 °C unter einem Stickstoffdruck von 65 bar kalziniert.
Nach Abkühlung wird der Leuchtstoff entnommen und in 100 ml VE-Wasser suspendiert. Die entstehende Suspension wird 30 Minuten gerührt, anschließend wird der Rührer ausgeschaltet. Nach einigen Minuten wird der Überstand abgegossen, der verbleibende Rückstand wird erneut in VE-Wasser aufgenommen, abgenutscht, mit VE-Wasser neutral gewaschen und getrocknet.

### Beispiel 3D: Herstellung des Leuchtstoffs (Sr,Ca)AlSiN₃:Eu

2,22 g Sr₃N₂, 0,33g Ca₃N₂, 0,05 g EuN, 1,23 g AIN und 1,4 g Siliciumnitrid werden in einer mit Stickstoff gefüllten Glovebox eingewogen und vermischt. Das entstandene Gemisch wird in einen Bornitrid-Tiegel gefüllt und in eine heißisostatische Presse (HIP) überführt. Es wurde ein Stickstoffdruck von 500 bar eingestellt, anschließend wurde das Material auf 1700 °C erhitzt und 4 Stunden bei dieser Temperatur getempert, hierbei stieg der Druck auf 1740 bar. Nach Abkühlung und Ventilation wurde das Material entnommen und in 100 ml VE-Wasser suspendiert. Die entstehende Suspension wird 30 Minuten gerührt, anschließend wird der Rührer ausgeschaltet. Nach einigen Minuten wird der Überstand abgegossen, der verbleibende Rückstand wird erneut in VE-Wasser aufgenommen, abgenutscht, mit VE-Wasser neutral gewaschen und getrocknet.

### 4. Herstellung der Leuchtstoffmischungen

### Beispiel 4.1: "SrLu_{1,98}Ce_{0,02}SiAl₄O₁₂ -Nitrid"

10 g des Leuchtstoffes aus Beispiel 1 werden mit 1 g des Leuchtstoffes aus Beispiel 3C innig vermischt.

Analog wird eine Mischung enthaltend die Leuchtstoffe aus Beispiel 1 und 3A bzw. 1 und 3B bzw. 1 und 3D hergestellt.

### Beispiel 5: Herstellung einer Leuchtdiode

Die Leuchtstoffmischung aus Beispiel 4.1 wird in einem Taumelmischer mit einem 2-Komponenten Silikon (OE 6550 der Fa. Dow Corning) gemischt, so dass gleiche Mengen der Leuchtstoffmischung in den beiden Komponenten des Silikons dispergiert sind; die Gesamtkonzentration der Leuchtstoffmischung im Silikon beträgt 8 Gew.-%.

5 ml jeder der beiden Leuchtstoff enthaltenden Silikon Komponenten werden homogen miteinander gemischt und in einen Dispenser überführt. Mit Hilfe des Dispensers werden leere LED packages von der Fa. OSA optoelectronics, Berlin, welche einen 100 µm² großen GaN Chip enthalten, befüllt. Danach werden die LEDs in eine Wärmekammer gestellt, um über 1 h bei 150°C das Silikon zu verfestigen.

**Tab. 1 zeigt die optischen Eigenschaften von SrLu_{1,98}Ce_{0,02}SiAl₄O₁₂ im Vergleich zu bekannten Leuchtstoffen gemäß US 2004/0062699.**

| **Zusammensetzung** | **Emissions-max. bei [nm]** | **CIE 1931 x, y** | **TQ₅₀-Wert [°C]** | **Licht-intensität^{*}** |
|---|---|---|---|---|
| SrLu_{1,98}Ce_{0,02}SiAl₄O₁₂ | 545 | 0.387 | 341 | 1.03 |
| | | 0.560 | | |
| BaY_{1,98}Ce_{0,02}SiAl₄O₁₂ | 552 | 0.429 | 289 | 0.84 |
| | | 0.543 | | |
| SrY_{1,98}Ce_{0,02}SiAl₄O₁₂ | 549 | 0.430 | 257 | 0.90 |
| | | 0.544 | | |
| BaLu_{1,98}Ce_{0,02}SiAl₄O₁₂ | 536 | 0,361 | 302 | 0.86 |
| | | 0,567 | | |

| | | | | |
|---|---|---|---|---|
| * *Lichtintensitäts-Werte wurden aus den Emissionsspektren (siehe* *Fig. 1 bis 3**) ermittelt* | | | | |

CIE x und CIE y stehen für die Koordinaten in dem dem Fachmann geläufigen CIE Normfarbdiagramm (hier Normalbeobachter 1931), mit denen die Farbe einer Lichtquelle beschrieben wird.
Alle oben aufgeführten Größen werden nach dem Fachmann geläufigen Methoden aus Emissionsspektren der Lichtquelle berechnet.

Der TQ₅₀-Wert ist die Temperatur, bei der das Emissionsspektrum eines Leuchtstoffs bzw. einer LED noch 50 % der Intensität aufweist, die es bei einer Temperatur von 0 °C hatte.

### Beschreibung der Figuren

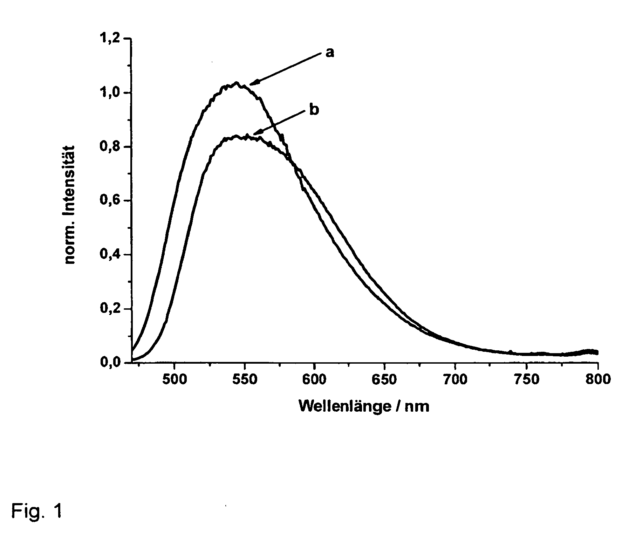

**Fig. 1****:** zeigt einen Vergleich der Emissionsspektren des erfindungsgemäßen Leuchtstoffes (a) SrLu_{1,98}Ce_{0,02}SiAl₄O₁₂ (Peak bei 545 nm; norm. Intensität 1.03) mit dem Leuchtstoff (b) BaY_{1,98}Ce_{0,02}SiAl₄O₁₂ (Peak bei 552 nm; norm. Intensität 0.83) gemäß US 2004/0062699.
(Die Emissionsmessung wurde jeweils an einer optisch unendlich dicken Schicht des Leuchtstoffes bei einer Anregung von 450 nm mit einem Edinburgh Instruments Spektrometer OC290 bei Raumtemperatur durchgeführt.)

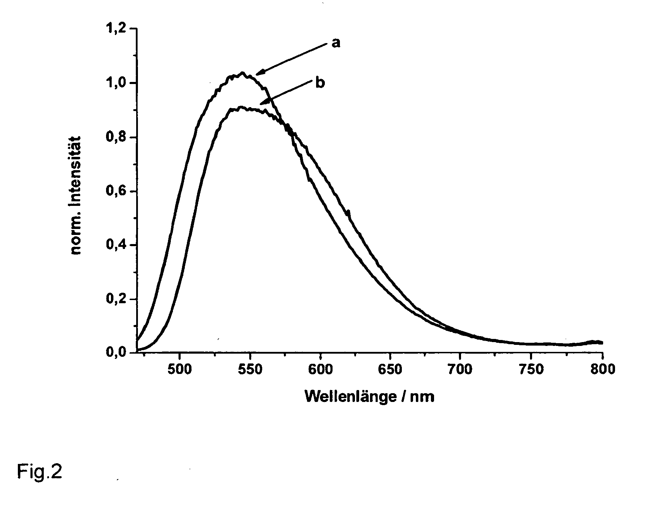

**Fig. 2****:** zeigt einen Vergleich der Emissionsspektren des erfindungsgemäßen Leuchtstoffes (a) SrLu_{1,98}Ce_{0,02}SiAl₄O₁₂ (Peak bei 545 nm; norm. Intensität 1.03) mit dem Leuchtstoff (b) SrY_{1,98}Ce_{0,02}SiAl₄O₁₂ (Peak bei 549 nm, norm. Intensität 0.90) gemäß US 2004/0062699.
(Die Emissionsmessung wurde jeweils an einer optisch unendlich dicken Schicht des Leuchtstoffes bei einer Anregung von 450 nm mit einem Edinburgh Instruments Spektrometer OC290 bei Raumtemperatur durchgeführt.)

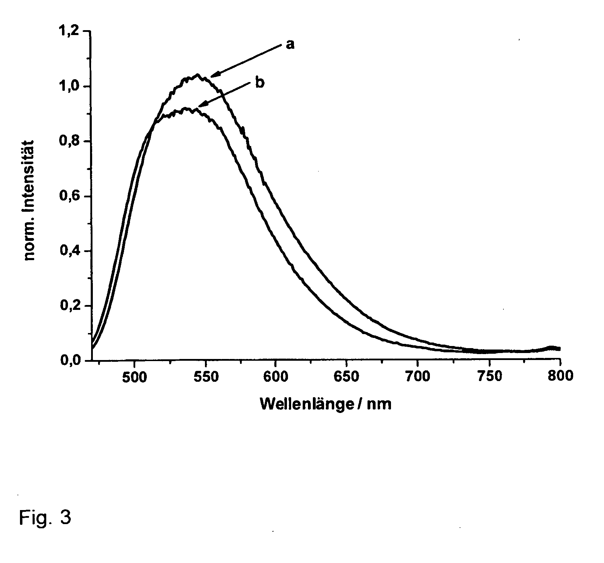

**Fig. 3****:** zeigt einen Vergleich der Emissionsspektren des erfindungsgemäßen Leuchtstoffes (a) SrLu_{1,98}Ce_{0,02}SiAl₄O₁₂ (Peak bei 545 nm; norm. Intensität 1.03) mit dem Leuchtstoff (b) BaLu_{1,98}Ce_{0,02}SiAl₄O₁₂ (Peak bei 536 nm, norm. Intensität 0.91) gemäß US 2004/0062699.
(Die Emissionsmessung wurde jeweils an einer optisch unendlich dicken Schicht des Leuchtstoffes bei einer Anregung von 450 nm mit einem Edinburgh Instruments Spektrometer OC290 bei Raumtemperatur durchgeführt.)

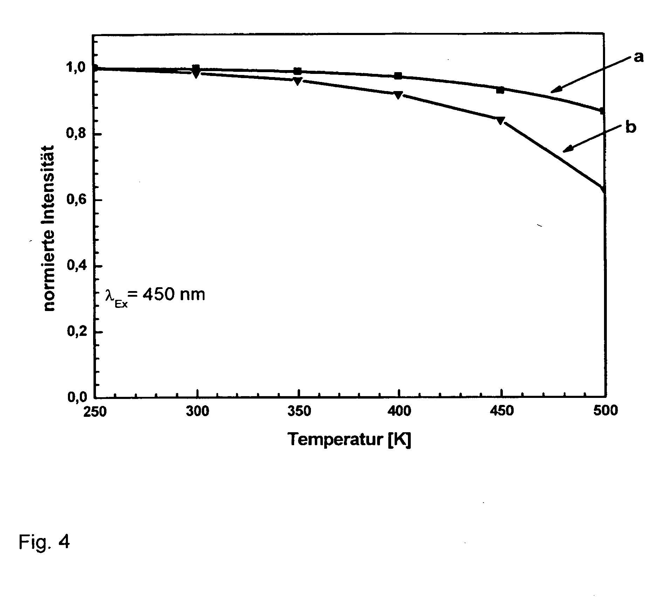

**Fig. 4****:** zeigt einen Vergleich der Temperaturstabilität (TQ₅₀) der Emissionsspektren (Anregung 450 nm) des erfindungsgemäßen Leuchtstoffes (a) SrLu_{1,98}Ce_{0,02}SiAl₄O_{12'} mit (b) SrY_{1,98}Ce_{0,02}SiAl₄O₁₂.
(Die TQ-Messung wurde am Edinburgh Instruments FLS920 mit einem Microstat N von Oxford Instruments durchgeführt. Als Anregungsquelle wurde eine 450Xe Hochdruckentladungslampe von OSRAM verwendet und als Detektor dient ein Single Photon Multiplier R2658P von Hamamatsu. Gemessen wurde in 50K Schritten von 250 K bis 500 K, Stabilisierungszeit 100s.)

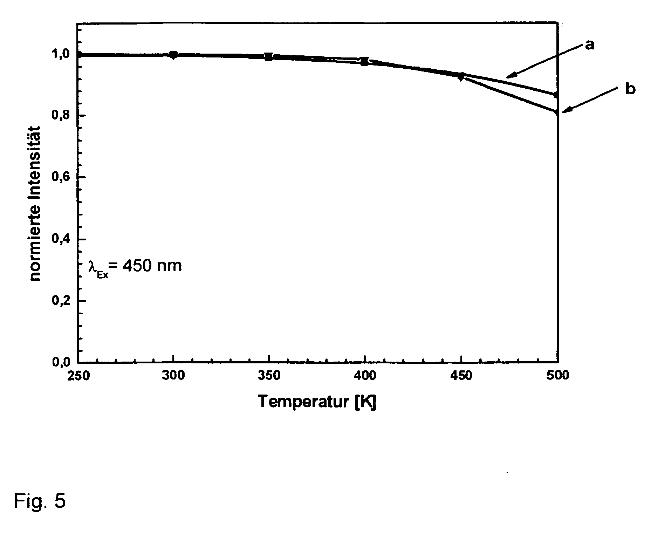

**Fig. 5****:** zeigt einen Vergleich der Temperaturstabilität (TQ₅₀) der Emissionsspektren (Anregung 450 nm) des erfindungsgemäßen Leuchtstoffes (a) SrLu_{1,98}Ce_{0,02}SiAl₄O_{12'} mit (b) BaY_{1,98}Ce_{0,02}SiAl₄O₁₂.
(Die TQ-Messung wurde am Edinburgh Instruments FLS920 mit einem Microstat N von Oxford Instruments durchgeführt. Als Anregungsquelle wurde eine 450Xe Hochdruckentladungslampe von OSRAM verwendet und als Detektor dient ein Single Photon Multiplier R2658P von Hamamatsu. Gemessen wurde in 50K Schritten von 250 K bis 500 K, Stabilisierungszeit 100s.)

## Patentansprüche

1. Verbindung der Formel I
SrLu₂₋ₓSiAl₄O₁₂:Ceₓ (I)
wobei
x steht für einen Wert aus dem Bereich von 0,01 bis 0,15.

2. Verbindung nach Anspruch 1, **dadurch gekennzeichnet, dass** x steht für einen Wert aus dem Bereich von 0,015 bis 0,12, vorzugsweise aus dem Bereich von 0,016 bis 0,10.

3. Verfahren zur Herstellung einer Verbindung gemäß Anspruch 1 oder 2 umfassend folgende Verfahrensschritte:
a) Mischen von Lutetium-, Cer-, Aluminium-, Strontium- und Silicium-haltigen Materialien,
b) Zugabe mindestens eines weiteren anorganischen und/oder organischen Stoffes,
c) thermische Nachbehandlung der mit Cer-aktivierten Verbindung.

4. Verfahren nach Anspruch 3, **dadurch gekennzeichnet, dass** die Verbindungen nasschemisch aus anorganischen und/oder organischen Metall- und/oder Seltenerd-Salzen mittels Sol-Gel-Verfahren, Präzipitations- und/oder Trocknungsverfahren, vorzugsweise Sprühtrocknung, hergestellt werden.

5. Verfahren nach Anspruch 3 oder 4, **dadurch gekennzeichnet, dass** die anorganischen oder organischen Stoffe (Verfahrenschritt b) ausgewählt werden aus der Gruppe der Ammoniumhalogenide, Erdalkalifluoride wie Calcium-, Strontium- oder Bariumfluorid, Borate, Borsäure, Carbonate, vorzugsweise Ammoniumhydrogencarbonat, Alkoholate wie Oxalate und/oder Kieselsäureester wie TEOS.

6. Mischung enthaltend mindestens eine Verbindung der Formel I nach Anspruch 1 oder 2 und mindestens einen rot emittierenden Leuchtstoff.

7. Mischung nach Anspruch 6, **dadurch gekennzeichnet, dass** mindestens ein rot emittierender Leuchtstoff ausgewählt ist aus Ce-dotierten Granaten, Eu-dotierten Thiogallaten, Eu-dotierten Sulfoseleniden und Eu- und/oder Ce-dotierten Nitriden, Oxynitriden, Alumonitriden und/oder Mn(IV) dotierten Oxiden und/oder Fluoriden.

8. Mischung nach Anspruch 6 oder 7, **dadurch gekennzeichnet, dass** mindestens ein rot emittierender Leuchtstoff ausgewählt ist aus nitridischen Leuchtstoffen, vorzugsweise (Ca,Sr,Ba)₂Si₅N₈:Eu, (Ca,Sr)AlSiN₃:Eu, (Ca,Sr;Ba)SiN₂:Eu, (Ca,Sr,Ba)₆Si₃O₆N₄:Eu, oder (Ca,Sr,Ba)_{2-x/2}Si₅N₈₋ₓOₓ:Eu, wobei x steht für eine Zahl aus dem Bereich 0,01 bis 3.

9. Verfahren zur Herstellung einer Mischung gemäß einem oder mehreren der Ansprüche 6 bis 8, **dadurch gekennzeichnet, dass** mindestens eine Verbindung der Formel I mit mindestens einem rot emittierenden Leuchtstoff gemischt wird.

10. Lichtquelle, **dadurch gekennzeichnet, dass** diese einen Halbleiter und mindestens einen Leuchtstoff nach Formel I gemäß Anspruch 1 oder 2 sowie mindestens einen rot emittierenden Leuchtstoff enthält.

11. Lichtquelle nach Anspruch 10, **dadurch gekennzeichnet, dass** es sich bei dem Halbleiter um ein lumineszentes IndiumAluminiumGalliumNitrid, insbesondere der Formel InᵢGaⱼAlₖN, wobei 0 ≤ i, 0 ≤ j, 0 ≤ k, und i+j+k=1 handelt.

12. Beleuchtungseinheit, insbesondere zur Hintergrundbeleuchtung von Anzeigevorrichtungen, **dadurch gekennzeichnet, dass** sie mindestens eine Lichtquelle nach den Ansprüchen 10 oder 11 enthält.

13. Beleuchtungseinheit nach Anspruch 12, **dadurch gekennzeichnet, dass** die optische Ankopplung zwischen dem Leuchtstoff und der Lichtquelle durch eine lichtleitende Anordnung realisiert ist.

14. Anzeigevorrichtung, insbesondere Flüssigkristallanzeigevorrichtung (LC Display), mit einer Hintergrundbeleuchtung, **dadurch gekennzeichnet, dass** sie mindestens eine Beleuchtungseinheit nach Anspruch 12 oder 13 enthält.

15. Verwendung von mindestens einer Verbindung nach Anspruch 1 oder 2 als Konversionsleuchtstoff zur teilweisen oder vollständigen Konversion der blauen oder im nahen UV-liegenden Emission einer Lumineszenzdiode.

## Claims

1. Compound of the formula I
SrLu₂₋ₓSiAl₄O₁₂:Ceₓ (I)
where
x stands for a value from the range from 0.01 to 0.15.

2. Compound according to Claim 1, **characterised in that** x stands for a value from the range from 0.015 to 0.12, preferably from the range from 0.016 to 0.10.

3. Process for the preparation of a compound according to Claim 1 or 2, comprising the following process steps:
a) mixing of lutetium-, cerium-, aluminium-, strontium- and silicon-containing materials,
b) addition of at least one further inorganic and/or organic substance,
c) thermal aftertreatment of the cerium-activated compound.

4. Process according to Claim 3, **characterised in that** the compounds are prepared by wet-chemical methods from inorganic and/or organic metal and/or rare-earth salts by means of sol-gel methods, precipitation methods and/or drying methods, preferably spray drying.

5. Process according to Claim 3 or 4, **characterised in that** the inorganic or organic substances (process step b) are selected from the group of the ammonium halides, alkaline-earth metal fluorides, such as calcium fluoride, strontium fluoride or barium fluoride, borates, boric acid, carbonates, preferably ammonium hydrogencarbonate, alcoholates, such as oxalates, and/or silicic acid esters, such as TEOS.

6. Mixture comprising at least one compound of the formula I according to Claim 1 or 2 and at least one red-emitting phosphor.

7. Mixture according to Claim 6, **characterised in that** at least one red-emitting phosphor is selected from Ce-doped garnets, Eu-doped thiogallates, Eu-doped sulfoselenides and Eu- and/or Ce-doped nitrides, oxynitrides, alumonitrides and/or Mn(IV)-doped oxides and/or fluorides.

8. Mixture according to Claim 6 or 7, **characterised in that** at least one red-emitting phosphor is selected from nitridic phosphors, preferably (Ca,Sr,Ba)₂Si₅N₈:Eu, (Ca,Sr)AlSiN₃:Eu, (Ca,Sr,Ba)SiN₂:Eu, (Ca,Sr,Ba)₆Si₃O₆N₄:Eu or (Ca,Sr,Ba)_{2-x/2}Si₅N₈₋ₓOₓ:Eu, where x stands for a number from the range 0.01 to 3.

9. Process for the preparation of a mixture according to one or more of Claims 6 to 8, **characterised in that** at least one compound of the formula I is mixed with at least one red-emitting phosphor.

10. Light source, **characterised in that** it comprises a semiconductor and at least one phosphor of the formula I according to Claim 1 or 2 and at least one red-emitting phosphor.

11. Light source according to Claim 10, **characterised in that** the semiconductor is a luminescent indium aluminium gallium nitride, in particular of the formula InᵢGaⱼAlₖN, where 0 ≤ i, 0 ≤ j, 0 ≤ k, and i + j + k = 1.

12. Lighting unit, in particular for the backlighting of display devices, **characterised in that** it comprises at least one light source according to Claim 10 or 11.

13. Lighting unit according to Claim 12, **characterised in that** the optical coupling between the phosphor and the light source is achieved by a light-conducting arrangement.

14. Display device, in particular liquid-crystal display device (LC display), having backlighting, **characterised in that** it comprises at least one lighting unit according to Claim 12 or 13.

15. Use of at least one compound according to Claim 1 or 2 as conversion phosphor for the partial or complete conversion of the blue or near-UV emission from a luminescent diode.

## Revendications

1. Composé de formule I
SrLu₂₋ₓSiAl₄O₁₂:Ceₓ (I)
dans lequel
x représente une valeur dans la plage allant de 0,01 à 0,15.

2. Composé selon la revendication 1, **caractérisé en ce que** x représente une valeur dans la plage allant de 0,015 à 0,12, préférablement dans la plage allant de 0,016 à 0,10.

3. Procédé de préparation d'un composé selon la revendication 1 ou 2, comprenant les étapes de procédé suivantes :
a) le mélange de matériaux contenant du lutétium, du cérium, de l'aluminium, du strontium et du silicium,
b) l'addition d'au moins une autre substance inorganique et/ou organique,
c) le post-traitement thermique du composé activé par cérium.

4. Procédé selon la revendication 3, **caractérisé en ce que** les composés sont préparés par des méthodes chimiques par voie humide à partir de sels de métaux et/ou de terres rares inorganiques et/ou organiques à l'aide de méthodes sol-gel, de méthodes de précipitation et/ou de méthodes de séchage, préférablement un séchage par pulvérisation.

5. Procédé selon la revendication 3 ou 4, **caractérisé en ce que** les substances inorganiques ou organiques (étape de procédé b) sont choisies dans le groupe constitué par les halogénures d'ammonium, les fluorures de métaux alcalino-terreux, tels que le fluorure de calcium, le fluorure de strontium ou le fluorure de baryum, les borates, l'acide borique, les carbonates, préférablement l'hydrogénocarbonate d'ammonium, les alcoolates, tels que les oxalates, et/ou les esters d'acide silicique, tels que le TEOS.

6. Mélange comprenant au moins un composé de formule I selon la revendication 1 ou 2 et au moins un luminophore émettant dans le rouge.

7. Mélange selon la revendication 6, **caractérisé en ce que** le au moins un luminophore émettant dans le rouge est choisi parmi les grenats dopés au Ce, les thiogallates dopés au Eu, les sulfoséléniures dopés au Eu et les nitrures dopés au Eu- et/ou au Ce, les oxynitrures, les nitrures d'aluminium et/ou les oxydes et/ou les fluorures dopés au Mn(IV).

8. Mélange selon la revendication 6 ou 7, **caractérisé en ce que** le au moins un luminophore émettant dans le rouge est choisi parmi les luminophores nitridiques, préférablement (Ca,Sr,Ba)₂Si₅N₈:Eu, (Ca,Sr)AlSiN₃:Eu, (Ca,Sr,Ba)SiN₂:Eu, (Ca,Sr,Ba)₆Si₃O₆N₄:Eu ou (Ca,Sr,Ba)_{2-x/2}Si₅N₈₋ₓOₓ:Eu, où x représente un nombre dans la plage allant de 0,01 à 3.

9. Procédé de préparation d'un mélange selon l'une ou plusieurs parmi les revendications 6 à 8, **caractérisé en ce qu'**au moins un composé de formule I est mélangé avec au moins un luminophore émettant dans le rouge.

10. Source lumineuse, **caractérisée en ce qu'**elle comprend un semi-conducteur et au moins un luminophore de formule I selon la revendication 1 ou 2 et au moins un luminophore émettant dans le rouge.

11. Source lumineuse selon la revendication 10, **caractérisée en ce que** le semi-conducteur est un nitrure de gallium-aluminium-indium luminescent, en particulier de formule InᵢGaⱼAlₖN, où 0 ≤ i, 0 ≤ j, 0 ≤ k, et i + j + k = 1.

12. Dispositif d'éclairage, en particulier pour le rétro-éclairage de dispositifs d'affichage, **caractérisé en ce qu'**il comprend au moins une source lumineuse selon la revendication 10 ou 11.

13. Dispositif d'éclairage selon la revendication 12, **caractérisé en ce que** le couplage optique entre le luminophore et la source lumineuse est réalisé par un montage conducteur de lumière.

14. Dispositif d'affichage, en particulier un dispositif d'affichage à cristaux liquides (affichage LC), pourvu d'un rétro-éclairage, **caractérisé en ce qu'**il comprend au moins un dispositif d'éclairage selon la revendication 12 ou 13.

15. Utilisation d'au moins un composé selon la revendication 1 ou 2 comme luminophore de conversion pour la conversion partielle ou complète d'une émission dans le bleu ou le proche ultraviolet à partir d'une diode luminescente.
